# EUROPEAN PATENT SPECIFICATION

(11) **EP 3 936 271 B1**
(45) Date of publication and mention of the grant of the patent: **25.09.2024**
(21) Application number: 21169170.4
(22) Date of filing: 19.04.2021
(51) Int. Cl.: B23K 1/08, B23K 3/06, B23K 3/08

(54) **SOLDERING NOZZLE, SYSTEM AND USE**
LÖTDÜSE, SYSTEM UND VERWENDUNG
BUSE DE BRASAGE, SYSTÈME ET UTILISATION

(30) Priority: 08.07.2020 EP 20184808
(43) Date of publication of application: 12.01.2022
(73) Proprietor: Illinois Tool Works, Inc., Glenview, Illinois 60025 (US)
(72) Inventor: COLIJN, Antonie Cornelis, Glenview, 60025 (US); DIEPSTRATEN, Gerardus Johannes Adrianus Maria, Glenview, 60025 (US)
(74) Representative: HGF

(56) References cited:
- EP-A1- 0 615 678
- EP-A1- 0 688 254
- EP-A1- 1 381 487
- EP-A1- 3 785 837
- EP-A1- 3 785 838
- US-A1- 2001 030 220
- US-A1- 2017 209 949
- US-B2- 6 913 183

## Description

The present disclosure relates to a soldering nozzle and in particular, but not exclusively, a nozzle for directing a stream of solder during a soldering operation. The present invention relates to a soldering nozzle according to independent claim 1, to a solder pot according to independent claim 6 and to the use of a solder pot according to claims 10 and 11.

### Background

Selective soldering can be used in many soldering applications, for example EP3785837A1, EP3785838A1 and US20010030220A1 disclose soldering components of a Printed Circuit Board (PCB). US20010030220A1 discloses a mounting device for controlling a mounted member in a wave solder machine, wherein the mounted member is a hot air knife used on a solder pot for debridging solder on a PCB after wave soldering.

EP0688254 B1 discloses a method of wave soldering an element characterized by covering at least a portion of the solder wave with a non-oxidizing gas.

Selective soldering can, in general, be differentiated into two methods: multi-wave dip soldering and point-to-point soldering.

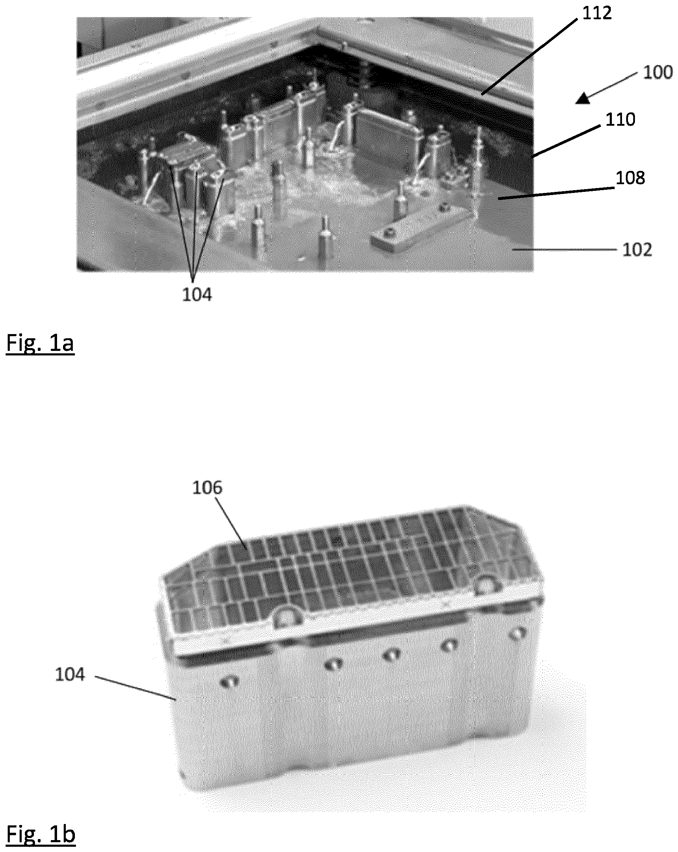

In multi-wave dip soldering processes, typically a large solder pot, or soldering assembly 100 is used (as shown in figure 1a) having a solder plate 102 that includes nozzles 104 to which liquidus solder is pumped. The soldering assembly 100 is typically closed with a cover plate, which has been removed in figure 1a in order to illustrate the nozzles 104 more clearly. Figure 1a shows that the nozzles 104 are provided in a cavity 108 defined by side walls 110. An upper part of the sidewalls 110 defines a lip 112 on which a cover plate is seated. The cover plate will include openings to expose the nozzles 104. As can be seen in figure 1a, the depth of the cavity 108 defined by the height of the sidewalls 110 is selected so that the top of each nozzle 104 will be generally at the same level as the cover plate. The cover plate serves to maintain a low oxygen environment around the nozzles during soldering. The PCB (not shown) is lowered towards the nozzles, such that connector leads/pins (for example in a Cu - Copper - panel) are dipped into the liquidus solder present in the nozzle to form solder connections/joints at corresponding locations on the PCB. That is, multiple solder connections can be formed simultaneously. Each multi-wave dip soldering assembly has a specific nozzle plate with the nozzles being located at the required solder positions. The nozzles may have different shapes depending on the connectors to be soldered and the free space on the assembly. Figure 1b illustrates a typical nozzle 104 used in a multi-wave dip soldering process. For connectors with a high risk of bridging, a laser-cut screen 106 (provided separately from the nozzle itself) may be provided in the nozzle 104 to help avoid bridging of solder.

In point-to-point soldering processes, typically a small solder pot, or soldering assembly, generally containing only one nozzle, is used. The nozzle comprises a body portion having an inlet at its lower end and an outlet for dispensing liquidus solder. In contrast to multi-wave soldering where the connectors pins are dipped into the nozzle, solder overflows from the outlet and a pin is dragged through or dipped into the flowing solder (or conversely the nozzle may be moved relative to the pin).

As noted above, multi-wave dip soldering processes suffer from the problem of bridging of solder between soldered pins or connectors, or between a soldered pin an another part of the PCB or other apparatus not being soldered. This can cause short circuiting. The known use of a nozzle screen, such as is illustrated in figure 1b, provides a partial solution to this bridging, and may thus be referred to as a de-bridging screen. However, such de-bridging screens can be delicate both in manufacture and in use, and are damaged easily (for instance if a pin or other part to be soldered is misaligned). Furthermore, screens (and hence the whole nozzle) must be designed specifically to match a product to be soldered, with holes to match the connectors to be soldered. This requires additional expense and production delay in exchanging nozzles if a solder pot is to be used to soldered different PCBs.

In addition, current methods of manufacturing the soldering components are limited with regards to the nozzle geometry that can be produced. This can lead to sub-optimal nozzles. The trend in the industry is that components are getting smaller. This miniaturization result in a smaller pitch between the pins. For pitches smaller than 2.00 mm it is not physically possible to make a screen because the distance has become too small, owing to it not being feasible to laser cut screens with smaller than 0.3 mm dimensions. It is a known problem of screens that flux residue from a PCB can clog a screen with small holes. During cleaning the screen may be damaged owing to its fragility. For these small pitches another de-bridging technology is required.

As used herein, when referring to 'solder' in use within a nozzle, it is to be understood that the solder is in a liquid state.

It would be advantageous to produce a soldering system that helps overcome the above described problems. Particularly, it would be advantageous to reduce occurrences of bridging during multi-wave dip soldering processes. It would be advantageous to provide a nozzle for multi-wave dip soldering processes that is more robust, less fragile and less sensitive for contamination and clogging. It would be advantageous to provide a nozzle for multi-wave dip soldering processes that is better able to accommodate different pins or components to be soldered.

### Summary of the Invention

The invention is defined in the appended claims.

According to a first aspect of the present disclosure there is provided a soldering nozzle for directing solder during a multi-wave soldering operation, the soldering nozzle comprising: a solder outlet for dispensing solder therefrom and to receive a plurality of parts to be soldered; and a de-bridging gas outlet arranged to direct de-bridging gas between a plurality of soldered parts after they exit the solder outlet.

According to a second aspect of the present disclosure there is provided a solder pot comprising: a solder plate; and at least one nozzle as described above, the at least one nozzle being provided on the solder plate such that liquidus solder and de-bridging gas can be supplied to the nozzle.

According to a third aspect of the present disclosure there is provided a solder pot comprising: a soldering nozzle for directing solder during a multi-wave soldering operation, the soldering nozzle comprising a solder outlet for dispensing solder therefrom and to receive a plurality of parts to be soldered; and a de-bridging gas outlet located relative to the soldering nozzle such that de-bridging gas is directed between a plurality of soldered parts after they exit the solder outlet.

According to a fourth aspect of the present disclosure there is provided a system for soldering a component, comprising: a supply of liquid solder; a solder pot as described above; and a pump configured to pump solder from the solder supply to the at least one nozzle of the soldering assembly.

According to a fifth aspect of the present disclosure there is provided the use of a soldering pot in a multi-wave soldering operation, the soldering pot comprising a nozzle including a solder outlet for dispensing solder therefrom and a de-bridging gas outlet arranged to direct de-bridging gas between a plurality of soldered parts after they exit the solder outlet.

For the avoidance of doubt, any of the features described herein apply equally to any aspect of the invention.

### Brief Description of the drawings

Embodiments of the invention are further described hereinafter with reference to the accompanying drawings, in which:
Figures 1a and 1b illustrates a perspective view of a solder pot and a nozzle (respectively) for use in multi-wave dip soldering processes;
Figure 2 illustrates a perspective view of a nozzle in accordance with an example of the present invention for use in multi-wave dip soldering processes;
Figure 3a illustrates an apparatus for transporting a PCB to a solder pot;
Figure 3b illustrates the apparatus of figure 3a performing multi-wave dip soldering;
Figure 4 illustrates a perspective view of a nozzle in accordance with another example of the present invention for use in multi-wave dip soldering processes;
Figure 5 illustrates a solder pot cover plate including an opening for a nozzle and a de-bridging gas outlet in accordance with a further example of the present invention; and
Figure 6 shows in detail the de-bridging gas outlet of figure 5, mounted upon a cover plate.

In the drawings like reference numerals refer to like parts.

### Detailed Description

In its most general form, a soldering assembly is disclosed including at least one nozzle for directing solder during a soldering operation. The soldering assembly may be a soldering assembly for use in multi-wave soldering process (typically including more than one nozzle).

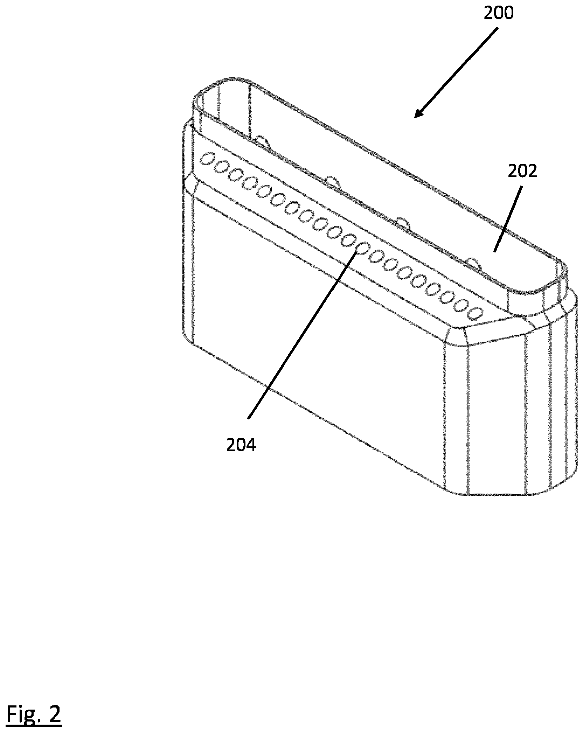

Referring to figure 2, this illustrates a soldering nozzle 200 according to an example of the present invention for directing solder during a multi-wave soldering operation. The nozzle 200 comprises a solder outlet 202 to which solder may be pumped. PCB leads, connectors, or other components to be soldered may be dipped into the solder outlet 202, as is conventional for a multi-wave soldering process, and in this respect nozzle 200 may be functionally the same as nozzle 104 illustrated in figure 1a. However, in accordance with an example of the present invention, nozzle 200 further comprises at least one de-bridging gas outlet 204. Figure 2 illustrates an example in where a plurality of de-bridging gas outlets 204 are arranged along one side of the solder outlet 202. After parts to be soldered are dipped into solder within the solder outlet 202 and then exit the solder outlet, the or each de-bridging gas outlet 204 is arranged to direct de-bridging gas between the soldered parts to remove solder in unwanted locations between the soldered parts, where otherwise there would be a risk of solder bridges forming.

The de-bridging gas may comprise nitrogen blown between soldered parts or leads to remove the solder when it is still liquidus. Other inert gases may also be used, and suitable inert de-bridging gases will be known to the skilled person. Other gases such as carbon dioxide may be suitable in some situations. The de-bridging gas may be heated to above the solder liquidus temperature. In some situations heating may not be required if solder adhering to the PCB is expected to remain above the liquidus temperature for long enough. After the PCB of other part being soldered is dipped in the solder, the de-bridging gas is blown underneath the board.

As de-bridging is performed by blowing de-bridging gas towards a PCB after parts to be soldered have been dipped in the solder outlet, there is no requirement for a screen across the solder outlet to perform de-bridging. The de-bridging gas may be blown continuously (at least during a particular soldering operation). In some alternatives, the de-bridging gas may be jetted intermittently when the PCB is located relative to the gas outlets 204 such that a location for which de-bridging is required is presented to a gas outlet 204. In some examples each of a plurality of gas outlets may be blowing de-bridging gas at the same time, or they may be separately controlled.

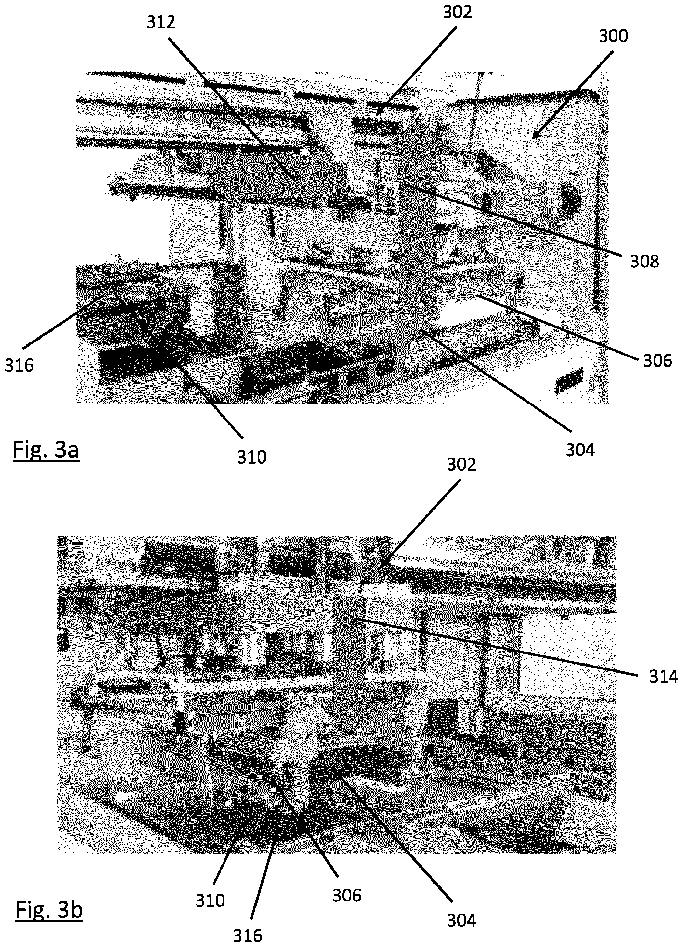

Referring now to figures 3a and 3b a soldering system 300 suitable for implementing multi-wave soldering including a nozzle according to figure 2 will be described. Other than the nozzle, the soldering system 300 may be similar to conventional multi-wave soldering processes. The soldering system 300 comprises a robot 302 (also referred to as an actuating means or translation means) arranged to pick up a PCB 304 from a conveyor, lift the PCB 304 into a shuttle 306 in the direction of arrow 308. The shuttle 306 then moves the PCB 304 to solder pot 310 in the direction of arrow 312. In figures 3a and 3b a cover plate 316 is visible which as described above closes off the top of the solder pot 310 except for openings where one or more nozzles are exposed (not clearly visible in figures 3a and 3b) in order to maintain a low oxygen environment during soldering.

The shuttle 306 then aligns the PCB 304 with solder pot 310 (and nozzle 200, though not visible in figures 3a and 3b) and lowers parts to be soldered into solder outlet 202 in the direction of arrow 314. The shuttle 306 then lifts the PCB 304 such that it clears the solder outlet 202. The de-bridging gas outlets 204 direct the de-bridging gas between the solder parts to prevent solder bridges forming. As noted above, the de-bridging gas outlets 204 may be continuously blowing de-bridging gas. As the shuttle 306 lifts the PCB 304 clear of the solder outlet 202, the solder parts move into the gas flow from outlets 204 such that de-bridging occurs. In some examples, after the PCB 304 is clear of the solder outlet 202 is may be transferred by the robot 302 such that the solder parts move through the gas flow.

Figure 2 illustrates an example of a nozzle 200 in which there is an array of de-bridging gas outlets located along one long side of a generally rectangular solder outlet. However it will be appreciated that this may vary. Firstly, the shape of the solder outlet may be dictated mainly by the shape and disposition of parts to be soldered in a multi-wave soldering process. Secondly, there may be only a single de-bridging gas outlet, or if there is a plurality then they may be arranged differently, for instance being provided on two sides of the solder outlet. In one example the de-bridging gas outlets are arranged on a downstream side of the nozzle, in the sense that after parts to be soldered are dipped into the solder outlet and then removed, they pass over the de-bridging gas outlets as they are transported out of the solder pot.

The flow rate, direction and temperature of the de-bridging gas defines if a bridge will be removed or not. Typically, the de-bridging gas is blown in between two leads. A flow rate will be configured to remove the solder bridge, and the flow rate may depend on the pitch between leads. For instance, to remove a bridge the flow rate may be 2-10 litres/minute. The flow rate may be proportional to the size of the nozzle, and in particular the size of the or each gas outlet 204. The gas temperature may be well above the melting point of the solder. However, in some examples the solder is expected to remain above the solder liquidus temperature at the time it is exposed to the de-bridging gas flow and so lower temperature gases may be used. Furthermore, where an array of de-bridging gas outlets are provided, it may be that all operate simultaneously to jet de-bridging gas towards a PCB to remove solder bridges across the whole PCB. Alternatively, in some examples the de-bridging gas outlets may be separately controlled to adjust or stop the flow of de-bridging gas.

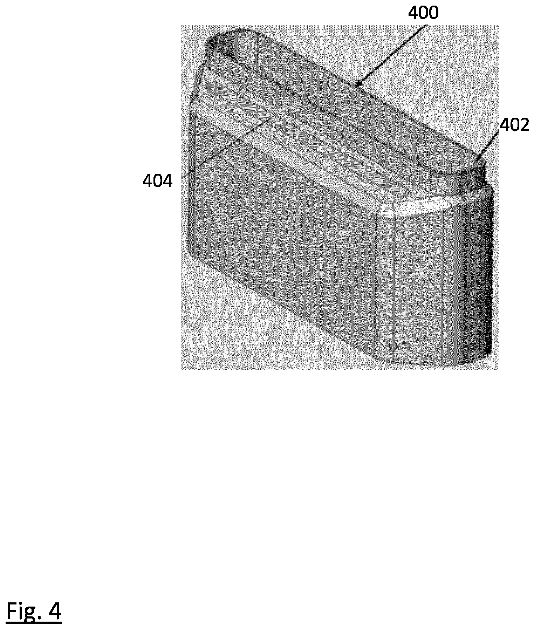

Referring now to figure 4, this illustrates a soldering nozzle 400 according to another example of the present invention for directing solder during a multi-wave soldering operation. The nozzle 400 is similar to the nozzle 200 illustrated in figure 2, and comprises a solder outlet 402 to which solder may be pumped. However, in place of an array of de-bridging gas outlets, a single elongate orifice 404 is provided, which acts as an air knife to direct a continuous jet of de-bridging gas across some or all of the width of the solder outlet 402. Other variations will be apparent to the skilled person, for instance an air knife broken into two or more sections or a combination of an array orifices with an air knife linearly arranged along a nozzle. In further examples it may be that a sequential (in the direction of PCB movement) series of de-bridging orifices or slots may be provided.

The nozzle incorporating the de-bridging gas outlets may be integrally formed. Suitably, it may be manufactured by 3D printing the nozzle. However, the present invention is not limited to the use of 3D printing. This makes it possible that provide substantially any required shape to define the channels for solder and de-bridging gas within the body of the nozzle itself. The nozzle will have a connection (nipple or threaded tube) to connect tubing for de-bridging gas supply, as well as a connection to a source of solder.

To 3D print the nozzle, the nozzle may include a plurality of stacked layers, for instance of stainless steel or titanium, provided so as to at least partially define the required channels. In this example, the stacked layers are deposited during an additive manufacturing, or 3D printing, process. That is, during construction, successive layers of stainless steel or titanium are deposited to build up the nozzle structure.

As an example of an additive manufacturing or 3D printing process, a thin layer (for example, of 20 to 100 microns thickness) of metal powder (for example stainless steel or titanium) is laid down on top of a build-plate. The powder is melted or welded together in predetermined positions, for example by a laser or welding means. The predetermined positions may be defined by a 3D CAD model, for example. The build-plate is lowered by a distance substantially corresponding to the thickness of the thin layer and these steps are repeated. Once the required number of layers have been added, the non-melted/welded powder is removed to reveal the component inside. The component may be heat treated to improve the mechanical properties or post-processed (for example turning, milling, tumbling or shot peening).

The construction of a nozzle in this way allows different shapes and models to be produced that would generally not be possible with milling, drilling or casting processes. As such, nozzles with improved functionality may be produced. In addition, the use of materials within the printed nozzles may be more efficient.

Previously, it would have been expected that a 3D printed component, such as the nozzle of this disclosure, would have a rough surface (as a result of the addition of successive layers). As such, there would be an expectation that the roughened surface of the nozzle (in particular, the surface defining the channel) may affect the nozzles ability to produce a consistent, laminar flow of solder. However, surprisingly, this has found to not be an issue for the 3D printed nozzle.

In a further example, the entire solder pot assembly may be 3D printed. That is, the solder pot may include a plurality of stacked layers of stainless steel or titanium.

The multi-wave soldering nozzles of figures 2 and 4 incorporate an integral de-bridging gas outlet, which may for instance be suitably formed through 3D printing the nozzle. However, according to other example embodiments, it is not essential that the de-bridging gas outlet is integrally formed with the solder nozzle, only that it be provided proximal to the nozzle at a location such that when the soldered parts of the PCB are lifted clear of the solder outlet (or as the PCB is moved downstream), de-bridging gas is blown across the solder parts to perform de-bridging. Suitably this may be achieved by providing a de-bridging gas outlet (which may be referred to as an air-knife) to a cover plate, at or close to an opening for a nozzle. However, the de-bridging gas outlet may be supported or positioned independently of the cover plate. The de-bridging gas outlet may be fixed in position relative to the solder nozzle.

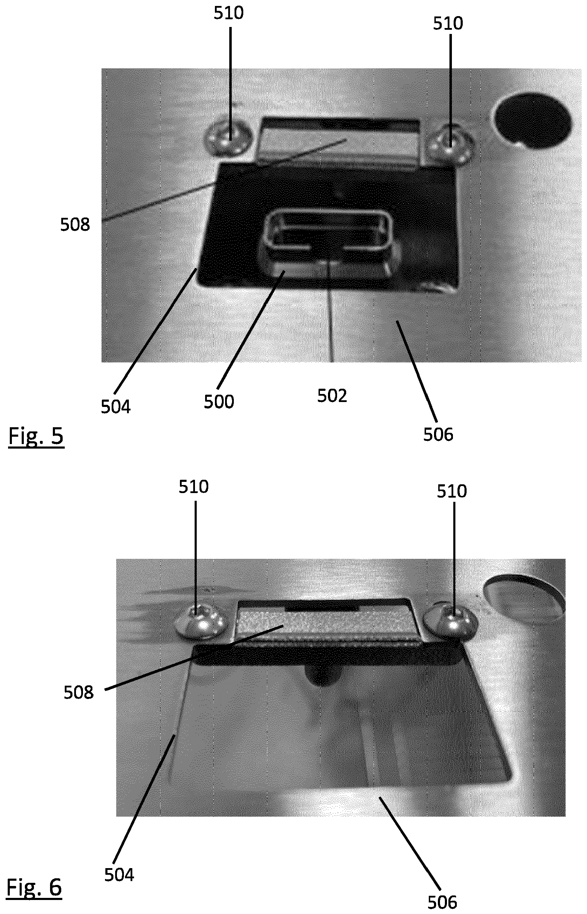

Referring now to figures 5 and 6, these illustrate a portion of a solder pot in accordance with a further example of the present invention in which a cover plate includes an opening for a nozzle and a de-bridging gas outlet. Solder nozzle 500 is shown, including solder outlet 502. As the nozzle 500 does not incorporate a de-bridging gas outlet, it may be generally similar to nozzle 104 of figure 1b, though no screen 106 is required. Nozzle 500, and particularly solder outlet 502, is shown exposed within opening 504 of cover plate 506. Cover plate 506 closes off the solder pot cavity as described above in connection with figure 1a, though only the portion surrounding opening 504 is shown in figures 5 and 6. It will be appreciated that cover plate 506 may include further openings associated with further nozzles.

Figures 5 and 6 further show a de-bridging gas outlet 508 in the form of an air knife with a single elongate gas outlet. It will be appreciated that alternatively two or more discrete gas openings may be provided. In the example of figures 5 and 6 the de-bridging gas outlet 508 is 3D printed and secured to the cover plate 506 with screws 510. However, it will be appreciated firstly that 3D printing is only one suitable fabrication technique and secondly that alternative fixation techniques will be well known to the skilled person. Indeed, in some examples the de-bridging gas outlet 508 may be integrally formed with the cover plate 506 itself. It can be seen that the de-bridging gas outlet 508 is directed towards the solder outlet 502 so that gas will be blown across parts of the PCB as they are lifted clear of the solder outlet 502, or moved downstream from the solder outlet 502 over the de-bridging gas outlet 508.

It will be clear to a person skilled in the art that features described in relation to any of the embodiments described above can be applicable interchangeably between the different embodiments. The embodiments described above are examples to illustrate various features of the invention.

## Claims

1. A soldering nozzle (200,400) for directing solder during a multi-wave soldering operation, the soldering nozzle (200,400) comprising:
a solder outlet (202,402) for dispensing solder therefrom and to receive a plurality of parts to be soldered; and
a de-bridging gas outlet (204) arranged to direct de-bridging gas between a plurality of soldered parts after they exit the solder outlet (202,402),
**characterised in that**
the solder outlet (202,402) and the de-bridging gas outlet (204) are integrally formed.

2. A soldering nozzle (200,400) according to claim 1, further comprising:
a solder channel having a solder inlet for receiving a supply of solder and the solder outlet (202,402) for dispensing solder therefrom; and
a de-bridging gas channel having a de-bridging gas inlet and the de-bridging gas outlet (204).

3. A soldering nozzle (200,400) according to any one of the preceding claims, wherein the nozzle (200,400) comprises a plurality of de-bridging gas outlets (204) arranged relative to the solder outlet (202,402) such that de-bridging gas is directed between the plurality of soldered parts to remove solder bridging after the soldered parts exit the solder outlet (202,402).

4. A soldering nozzle (200,400) according to claim 3, wherein the plurality of de-bridging gas outlets (204) are arranged along a first side of the solder outlet (202,402).

5. A solder pot (310) comprising:
a solder plate; and
at least one nozzle (200,400) according to any one of claims 1 to 4, the at least one nozzle (200,400) being provided on the solder plate such that liquidus solder and de-bridging gas can be supplied to the nozzle (200,400).

6. A solder pot comprising:
a soldering nozzle (500) for directing solder during a multi-wave soldering operation, the soldering nozzle (500) comprising a solder outlet (502) for dispensing solder therefrom and to receive a plurality of parts to be soldered; and
a de-bridging gas outlet (508) located relative to the soldering nozzle (500) such that de-bridging gas is directed between a plurality of soldered parts after they exit the solder outlet,
wherein the soldering nozzle and the de-bridging gas outlet (204) are arranged in a fixed spatial arrangement,
**characterised in that**
the solder pot further comprises a cover plate (506), wherein the cover plate (506) incorporates an opening (504) to expose the solder outlet (502), and wherein the de-bridging gas outlet (508) is coupled to or incorporated into the cover plate (506), and
wherein the de-bridging gas outlet (508) is provided at or proximal to an edge of the opening (504).

7. The solder pot according to claim 6, wherein the at least one soldering nozzle (500) is provided on a solder plate such that liquidus solder and de-bridging gas can be supplied to the nozzle (500).

8. A system for soldering a component, comprising
a supply of liquidus solder;
a solder pot (310) according to any one of claims 5 to 7; and
a pump configured to pump solder from the solder supply to the at least one nozzle (200,400, 500) of the soldering assembly.

9. A system according to claim 8, further comprising:
a supply of de-bridging gas coupled to the de-bridging gas outlet (204, 508).

10. Use of a solder pot (310) in a multi-wave soldering operation, the solder pot (310) comprising a nozzle (200,400) including a solder outlet for dispensing solder therefrom and a de-bridging gas outlet (204) arranged to direct de-bridging gas between a plurality of soldered parts after they exit the solder outlet (202,402), **characterised in that** the solder outlet (202,402) and the de-bridging gas outlet (204) are integrally formed.

11. Use of a solder pot (310) in a multi-wave soldering operation, wherein the solder pot comprises a soldering nozzle (500) for directing solder during a multi-wave soldering operation, the soldering nozzle (500) comprising a solder outlet (502) for dispensing solder therefrom and to receive a plurality of parts to be soldered; and
a de-bridging gas outlet (508) located relative to the soldering nozzle (500) such that de-bridging gas is directed between a plurality of soldered parts after they exit the solder outlet (502),
wherein the soldering nozzle (500) and the de-bridging gas outlet (508) are arranged in a fixed spatial arrangement,
wherein the solder pot further comprises a cover plate (506), wherein the cover plate (506) incorporates an opening (504) to expose the solder outlet (502), and wherein the de-bridging gas outlet (508) is coupled to or incorporated into the cover plate (506), and
wherein the de-bridging gas outlet (508) is provided at or proximal to an edge of the opening (504).

## Patentansprüche

1. Lötdüse (200, 400) zum Leiten von Lot während eines Mehrwellenlötvorgangs, wobei die Lötdüse (200, 400) aufweist:
einen Lotauslass (202, 402) zur Abgabe von Lot daraus und zur Aufnahme einer Vielzahl von zu lötenden Teilen; und
einen Brückenentfernungs-Gasauslass (204), der angeordnet ist, um Brückenentfernungs-Gas zwischen eine Vielzahl von gelöteten Teilen zu leiten, nachdem sie den Lotauslass (202, 402) verlassen haben,
**dadurch gekennzeichnet, dass**
der Lotauslass (202, 402) und der Brückenentfernungs-Gasauslass (204) einstückig gebildet sind.

2. Lötdüse (200, 400) nach Anspruch 1, ferner aufweisend:
einen Lotkanal, der einen Loteinlass zur Aufnahme eines Lotvorrats und den Lotauslass (202, 402) zur Abgabe von Lot daraus aufweist; und
einen Brückenentfernungs-Gaskanal, der einen Brückenentfernungs-Gaseinlass und den Brückenentfernungs-Gasauslass (204) aufweist.

3. Lötdüse (200, 400) nach einem der vorhergehenden Ansprüche, wobei die Düse (200, 400) eine Vielzahl von Brückenentfernungs-Gasauslässen (204) aufweist, die relativ zu dem Lotauslass (202, 402) so angeordnet sind, dass das Brückenentfernungsgas zum Entfernen von Lötbrücken zwischen die Vielzahl von gelöteten Teilen geleitet wird, nachdem die gelöteten Teile den Lotauslass (202, 402) verlassen haben.

4. Lötdüse (200, 400) nach Anspruch 3, wobei die Vielzahl der Brückenentfernungs-Gasauslässe (204) entlang einer ersten Seite des Lotauslasses (202, 402) angeordnet ist.

5. Lottopf (310), aufweisend:
eine Lötplatte; und
zumindest eine Düse (200, 400) nach einem der Ansprüche 1 bis 4, wobei die zumindest eine Düse (200, 400) so auf der Lötplatte vorgesehen ist, dass der Düse (200, 400) Liquidus-Lot und Brückenentfernungsgas zugeführt werden kann.

6. Lottopf, aufweisend:
eine Lötdüse (500) zum Leiten von Lot während eines Mehrwellenlötvorgangs, wobei die Lötdüse (500) einen Lotauslass (502) zum Abgeben von Lot daraus und zur Aufnahme einer Vielzahl von zu lötenden Teilen aufweist; und
einen Brückenentfernungs-Gasauslass (508), der relativ zu dem Lotauslass (500) so angeordnet ist, dass das Brückenentfernungsgas zwischen eine Vielzahl von gelöteten Teilen geleitet wird, nachdem sie den Lotauslass verlassen haben,
wobei die Lötdüse und der Brückenentfernungs-Gasauslass (204) in einer festen räumlichen Anordnung angeordnet sind, **dadurch gekennzeichnet, dass**
der Lottopf ferner eine Abdeckplatte (506) aufweist, wobei die Abdeckplatte (506) eine Öffnung (504) zum Freilegen des Lotauslasses (502) aufweist, und wobei der Brückenentfernungs-Gasauslass (508) mit der Abdeckplatte (506) verbunden oder in diese integriert ist, und
wobei der Brückenentfernungs-Gasauslass (508) an oder in der Nähe einer Kante der Öffnung (504) vorgesehen ist.

7. Lottopf nach Anspruch 6, wobei die zumindest eine Lötdüse (500) auf einer Lötplatte vorgesehen ist, sodass der Düse (500) Liquidus-Lot und Brückenentfernungsgas zugeführt werden kann.

8. System zum Löten eines Bauteils, aufweisend
einen Vorrat an Liquidus-Lot;
einen Lottopf (310) nach einem der Ansprüche 5 bis 7; und
eine Pumpe, ausgebildet zum Pumpen von Lot aus dem Lotvorrat zu der zumindest einen Düse (200, 400, 500) der Lötbaugruppe.

9. System nach Anspruch 8, ferner aufweisend:
eine mit dem Brückenentfernungs-Gasauslass (204, 508) verbundene Brückenentfernungs-Gasversorgung.

10. Verwendung eines Lottopfes (310) in einem Mehrwellenlötverfahren, wobei der Lottopf (310) eine Düse (200, 400) aufweist, die einen Lotauslass zum Ausgeben von Lot daraus und einen Brückenentfernungs-Gasauslass (204) aufweist, der zum Leiten von Brückenentfernungsgas zwischen eine Vielzahl von gelöteten Teilen angeordnet ist, nachdem diese den Lotauslass (202, 402) verlassen haben, **dadurch gekennzeichnet, dass** der Lotauslass (202, 402) und der Brückenentfernungs-Gasauslass (204) einstückig ausgebildet sind.

11. Verwendung eines Lottopfes (310) in einem Mehrwellenlötvorgang, wobei der Lottopf eine Lötdüse (500) zum Leiten von Lot während eines Mehrwellenlötvorgangs aufweist, wobei die Lötdüse (500) einen Lotauslass (502) zum Abgeben von Lot daraus und zum Aufnehmen einer Vielzahl von zu lötenden Teilen aufweist; und
einen Brückenentfernungs-Gasauslass (508), der relativ zu dem Lotauslass (500) so angeordnet ist, dass das Brückenentfernungsgas zwischen eine Vielzahl von gelöteten Teilen geleitet wird, nachdem sie den Lotauslass (502) verlassen haben,
wobei die Lötdüse (500) und der Brückenentfernungs-Gasauslass (508) in einer festen räumlichen Anordnung angeordnet sind,
wobei der Lottopf ferner eine Abdeckplatte (506) aufweist, wobei die Abdeckplatte (506) eine Öffnung (504) zum Freilegen des Lotauslasses (502) aufweist, und wobei der Brückenentfernungs-Gasauslass (508) mit der Abdeckplatte (506) verbunden oder in diese integriert ist, und
wobei der Brückenentfernungs-Gasauslass (508) an oder in der Nähe einer Kante der Öffnung (504) vorgesehen ist.

## Revendications

1. Buse de soudage (200, 400) pour la direction de la soudure durant une opération de soudage à ondes multiples, la buse de soudage (200, 400) comprenant :
une sortie de soudure (202, 402) pour la distribution de soudure à partir de celle-ci et pour recevoir une pluralité de pièces à souder ; et
une sortie de gaz de dévoutage (204) agencée pour diriger le gaz de dévoutage entre une pluralité de pièces soudées après qu'elles ont quitté la sortie de soudure (202, 402),
**caractérisée en ce que**
la sortie de soudure (202, 402) et la sortie de gaz de dévoutage (204) sont formées d'un seul tenant.

2. Buse de soudage (200, 400) selon la revendication 1, comprenant en outre :
un canal de soudure ayant une entrée de soudure pour la réception d'une alimentation de soudure et la sortie de soudure (202, 402) pour la distribution de la soudure à partir de celle-ci ; et
un canal de gaz de dévoutage ayant une entrée de gaz de dévoutage et la sortie de gaz de dévoutage (204).

3. Buse de soudage (200, 400) selon l'une quelconque des revendications précédentes, dans laquelle la buse (200, 400) comprend une pluralité de sorties de gaz de dévoutage (204) agencées par rapport à la sortie de soudure (202, 402) de sorte que le gaz de dévoutage est dirigé entre la pluralité de pièces soudées pour éliminer le voutage de soudure après que les pièces soudées ont quitté la sortie de soudure (202, 402).

4. Buse de soudage (200, 400) selon la revendication 3, dans laquelle la pluralité de sorties de gaz de dévoutage (204) sont agencées le long d'un premier côté de la sortie de soudure (202, 402).

5. Pot de soudure (310) comprenant :
une plaque de soudure ; et
au moins une buse (200, 400) selon l'une quelconque des revendications 1 à 4, l'au moins une buse (200, 400) étant disposée sur la plaque de soudure de sorte que la soudure liquide et le gaz de dévoutage puissent être fournis à la buse (200, 400) .

6. Pot de soudure comprenant :
une buse de soudage (500) pour la direction de la soudure durant une opération de soudage à ondes multiples, la buse de soudage (500) comprenant une sortie de soudure (502) pour la distribution de la soudure à partir de celle-ci et pour recevoir une pluralité de pièces à souder ; et
une sortie de gaz de dévoutage (508) située par rapport à la buse de soudage (500) de sorte que le gaz de dévoutage est dirigé entre une pluralité de pièces soudées après qu'elles ont quitté la sortie de soudure,
dans lequel la buse de soudage et la sortie de gaz de dévoutage (204) sont agencées dans un agencement spatial fixe,
**caractérisé en ce que**
le pot de soudure comprend en outre une plaque de couverture (506), dans lequel la plaque de couverture (506) incorpore une ouverture (504) pour exposer la sortie de soudure (502), et dans lequel la sortie de gaz de dévoutage (508) est couplée à ou incorporée dans la plaque de couverture (506), et
dans lequel la sortie de gaz de dévoutage (508) est disposée au niveau ou à proximité d'un bord de l'ouverture (504) .

7. Pot de soudage selon la revendication 6, dans lequel l'au moins une buse de soudage (500) est disposée sur une plaque de soudure de sorte qu'une soudure liquide et un gaz de dévoutage peuvent être fournis à la buse (500).

8. Système de soudage d'un élément, comprenant
une alimentation de soudure liquide ;
un pot de soudage (310) selon l'une quelconque des revendications 5 à 7 ; et
un pompe, configurée pour pomper de la soudure à partir de l'alimentation de soudure vers l'au moins une buse (200, 400, 500) de l'ensemble de soudage.

9. Système selon la revendication 8, comprenant en outre :
une alimentation de gaz de dévoutage couplée à la sortie de gaz de dévoutage (204, 508).

10. Utilisation d'un pot de soudure (310) dans une opération de soudure à ondes multiples, le pot de soudure (310) comprenant une buse (200, 400) comprenant une sortie de soudure pour la distribution de soudure à partir de celle-ci et une sortie de gaz de dévoutage (204) agencée pour diriger le gaz de dévoutage entre une pluralité de pièces soudées après qu'elles ont quitté la sortie de soudure (202, 402), **caractérisée en ce que** la sortie de soudure (202, 402) et la sortie de gaz de dévoutage (204) sont formées d'un seul tenant.

11. Utilisation d'un pot de soudure (310) dans une opération de soudure à ondes multiples, dans laquelle le pot de soudure comprend une buse de soudage (500) pour la direction de la soudure durant une opération de soudage à ondes multiples, la buse de soudage (500) comprenant une sortie de soudure (502) pour la distribution de la soudure à partir de celle-ci et pour recevoir une pluralité de pièces à souder ; et
une sortie de gaz de dévoutage (508) située par rapport à la buse de soudage (500) de sorte que le gaz de dévoutage est dirigé entre une pluralité de pièces soudées après qu'elles ont quitté la sortie de soudure (502),
dans laquelle la buse de soudage (500) et la sortie de gaz de dévoutage (508) sont agencées dans un agencement spatial fixe,
dans laquelle le pot de soudure comprend en outre une plaque de couverture (506), dans laquelle la plaque de couverture (506) incorpore une ouverture (504) pour exposer la sortie de soudure (502), et dans laquelle la sortie de gaz de dévoutage (508) est accouplée à ou incorporée dans la plaque de couverture (506), et
dans laquelle la sortie de gaz de dévoutage (508) est disposée au niveau ou à proximité d'un bord de l'ouverture (504) .
